(19) Europäisches Patentamt / European Patent Office / Office européen des brevets

(11) **EP 4 435 716 A1**

(12) **EUROPEAN PATENT APPLICATION**

(43) Date of publication:
**25.09.2024 Bulletin 2024/39**

(21) Application number: **23163541.8**

(22) Date of filing: **22.03.2023**

(51) International Patent Classification (IPC):
**G06T 7/00** $^{(2017.01)}$     **G01R 31/309** $^{(2006.01)}$
**G01N 21/956** $^{(2006.01)}$     **G06N 3/02** $^{(2006.01)}$
**H05K 13/08** $^{(2006.01)}$

(52) Cooperative Patent Classification (CPC):
**G06T 7/0004; G01R 31/309;** G01N 2021/95638;
G06N 3/045; G06N 3/048; G06N 3/084;
G06T 2207/20081; G06T 2207/20084;
G06T 2207/30141

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Aktiengesellschaft
80333 München (DE)**

(72) Inventors:
• **Krompaß, Denis
81549 München (DE)**
• **Eichler, Roman
90451 Nürnberg (DE)**
• **Mallandur, Adarsh
91052 Erlangen (DE)**

(74) Representative: **Siemens Patent Attorneys
Postfach 22 16 34
80506 München (DE)**

(54) **SYSTEM FOR OPTIMIZING THE AUTOMATED OPTICAL INSPECTION OF PRINTED CIRCUIT BOARDS AND METHOD THEREOF**

(57) The present invention relates to a system for optimizing the automated optical inspection of printed circuit boards, comprising: an input data interface, configured to obtain data from a printed circuit board produced by an automated optical inspection machine, wherein the data contains a number of measured features; a classification module, configured to implement an artificial neural network, trained and adapted to generate a classification of the obtained data based on a number of test patterns; an application module, configured to implement one or more applications from a set of applications using the generated classification as input; and an output interface, configured to output a signal based on the outcome of the one or more implemented applications.

FIG 1

EP 4 435 716 A1

**Description**

The present invention relates to a system and a computer-implemented method for optimizing the automated optical inspection of printed circuit boards.

The invention is mostly described with respect to a reduction of the false-positive predictions of automated optical inspection (AOI) machines but the principles of the invention have a broader scope and apply equally well to other applications or services related to the AOI.

Herein and in the forthcoming, independent of the grammatical term usage, individuals with male, female or other gender identities are included within the term.

Automated optical inspection (AOI) machines are routinely used to provide a visual inspection of printed circuit boards (PCB), liquid crystal display devices (LCD) or transistors at different stages of their manufacturing process in order to test for defects such as missing or misplaced electronic components. This quality inspection takes places with an automated camera scan, where measured features are processed and, based on a number of test patterns, faulty boards are identified and can be send back to the assembly line to get fixed.

This procedure is known to originate a considerable quantity of false positives, i.e., boards that are misidentified as faulty. In practice, in order to avoid rejecting correctly assembled PCBs, the boards tagged by the AOI machine as faulty are manually inspected. This manual inspection is tedious and time-consuming.

Automation of this manual inspection can be achieved employing artificial intelligence. However, most of the conventional machine learning implementations rely on image data, which is not always made available by the AOI machine vendors.

An alternative that has been recently proposed is to use the data produced by the AOI machine after its processing into images. So far, the main focus has been the detection of false positives mimicking the manual procedure, and the artificial intelligence architectures used have been built with this goal in mind.

Against this background, the problem addressed by the present invention is to extend the scope of applications of such artificial intelligence solutions by providing a system and method for optimizing the automated optical inspection of printed circuit boards, especially to reduce the number of false positive predictions but also by building a downstream value chain of added services.

This problem is solved according to the invention amongst others by a system having the features of claim 1 and/or by a computer-implemented method having the features of claim 13.

A first aspect of the invention provides a system for optimizing the automated optical inspection of printed circuit boards, comprising: an input data interface, configured to obtain data from a printed circuit board produced by an automated optical inspection machine, wherein the data contains a number of measured features; a classification module, configured to implement an artificial neural network, trained and adapted to generate a classification of the obtained data based on a number of test patterns; an application module, configured to implement one or more applications from a set of applications using the generated classification as input; and an output interface, configured to output a signal based on the outcome of the one or more implemented applications.

In the present invention, under an automated optical inspection (AOI) machine it is to be understood any device, typically comprising an optical scanning unit (e.g., a camera) and a computation unit with a detection algorithm, for the quality control of printed board circuits (PCBs) on assembly lines, wherein the detection algorithm is adapted to detect defects or deficiencies on manufactured PCBs.

Test patterns are standard templates or macros implemented in the detection algorithms of the AOI machines to aid them in the detection of deficiencies or defects during the optical inspection of the PCBs.

The obtained data is data generated by the detection algorithms of AOI machines, typically comprising a combination of metadata and measured features for every measurement, where each measurement corresponds to a scanned window of the PCB where a test pattern is applied.

Herein and in the forthcoming, an artificial neural network (or encoder) is to be understood as a computing system based on a collection of connected units or nodes aggregated into layers able to transmit signals to each other, preferably comprising at least partially a transformer neural network architecture.

A classification will be understood as the identification of the data corresponding to a measurement with one category or class among a set of categories or classes, wherein the categories or classes are determined and defined by a set of test patterns. In this application, the result of the classification is an encoding of the test patterns.

Applications are to be understood as any computer-aided post-processing of the encoding of a set of test patterns, adapted to solve a specific task.

Measured features are the outputs of the applied detection algorithm of an AOI machine when a test pattern is applied for the detection of defects or deficiencies on a PCB or a part thereof. Measured features are numerical values which, together with a knowledge of the distribution of the numerical values and knowledge of the electronic component under examination, can determine the different test patterns.

The input data interface, the computing module, the application module, the output interface and the different units mentioned in this application are broadly understood as entities capable of acquiring, obtaining, receiving or retrieving generic data and/or instructions through a user interface and/or programming code and/or executable programs or any combination thereof. In particular, the computing module, the application module and the different units mentioned hereafter are adapted to run programming code and executable programs and to deliver the results for further processing.

The input data interface, the computing module, the application module, the output interface and the different units mentioned hereafter, or parts thereof, may therefore each contain, at least, a central processing unit, CPU, and/or at least one graphics processing unit, GPU, and/or at least one field-programmable gate array, FPGA, and/or at least one application-specific integrated circuit, ASIC and/or any combination of the foregoing. Each of them may further comprise a working memory operatively connected to the at least one CPU and/or a non-transitory memory operatively connected to the at least one CPU and/or the working memory. Each of them may be implemented partially and/or completely in a local apparatus and/or partially and/or completely in a remote system such as by a cloud computing platform.

All of the elements of the system of the invention may be realized in hardware and/or software, cable-bound and/or wireless, and in any combination thereof. Any of the elements may comprise an interface to an intranet or the Internet, to a cloud computing service, to a remote server and/or the like.

In particular, the system of the invention may be implemented partially and/or completely in a local apparatus, e.g. a computer, in a system of computers and/or partially and/or completely in a remote system such as a cloud computing platform.

In systems based on cloud computing technology, a large number of devices is connected to a cloud computing system via the Internet. The devices may be located in a remote facility connected to the cloud computing system. For example, the devices can comprise, or consist of, equipment, sensors, actuators, robots, and/or machinery in an industrial set-up(s). The devices can be medical devices and equipment in a healthcare unit. The devices can be home appliances or office appliances in a residential/commercial establishment.

The cloud computing system may enable remote configuring, monitoring, controlling, and maintaining connected devices (also commonly known as 'assets'). Also, the cloud computing system may facilitate storing large amounts of data periodically gathered from the devices, analyzing the large amounts of data, and providing insights (e.g., Key Performance Indicators, Outliers) and alerts to operators, field engineers or owners of the devices via a graphical user interface (e.g., of web applications). The insights and alerts may enable controlling and maintaining the devices, leading to efficient and fail-safe operation of the devices. The cloud computing system may also enable modifying parameters associated with the devices and issues control commands via the graphical user interface based on the insights and alerts.

The cloud computing system may comprise a plurality of servers or processors (also known as 'cloud infrastructure'), which are geographically distributed and connected to each other via a network. A dedicated platform (hereinafter referred to as 'cloud computing platform') is installed on the servers/processors for providing above functionality as a service (hereinafter referred to as 'cloud service'). The cloud computing platform may comprise a plurality of software programs executed on one or more servers or processors of the cloud computing system to enable delivery of the requested service to the devices and its users.

One or more application programming interfaces (APIs) are deployed in the cloud computing system to deliver various cloud services to the users.

A second aspect of the present invention provides a computer-implemented method for optimizing the automated optical inspection of printed circuit boards, comprising the following steps: (a) obtaining data from a printed circuit board produced by an automated optical inspection machine, wherein the data contains a number of measured features; (b) generating, using an artificial neural network trained on a number of test patterns, a classification for the obtained data based on the number of test patterns; (c) implementing one or more applications from a set of applications using the generated classification as input; and (d) outputting a signal based on the outcome of the one or more implemented applications.

In particular, the method according to the second aspect of the invention may be carried out by the system according to the first aspect of the invention. The features and advantages disclosed herein in connection with the computing device are therefore also disclosed for the method, and vice versa.

According to a third aspect, the invention provides a computer program product comprising executable program code configured to, when executed, perform the method according to the second aspect of the present invention.

According to a fourth aspect, the invention provides a non-transient computer-readable data storage medium comprising executable program code configured to, when executed, perform the method according to the second aspect of the present invention.

The non-transient computer-readable data storage medium may comprise, or consist of, any type of computer memory, in particular semiconductor memory such as a solid-state memory. The data storage medium may also comprise, or consist of, a CD, a DVD, a Blu-Ray-Disc, an USB memory stick or the like.

According to a fifth aspect, the invention provides a data stream comprising, or configured to generate, executable program code configured to, when executed, perform the method according to the second aspect of the present invention.

According to a sixth aspect, the invention provides an automated inspection system for the optical inspection of printed circuit boards comprising an automated optical inspection machine and a system according to the first aspect of the present invention, wherein the system of the invention is provided as an application program interface (API) to the optical inspection machine.

One of the main ideas underlying the present invention is to provide a system which can provide, based on the features stored in the data obtained by an AOI machine from a printed circuit board under inspection, and using an artificial intelligence implementation, a classification of the data based on test patterns of printed circuit boards. The system is configured to transfer the generated classification to a number of machine learning applications aimed at optimizing the automated optical inspection of printed circuit boards.

The device as described above allows for a simple implementation of a computer-implemented method comprising a number of steps. In one step, data of a printed circuit board is obtained from an AOI machine, where this data contains a number of features. In another step, the features are recognized by an artificial neural network which, based upon the features, generates a test pattern classification of the data. In a subsequent step, one or more applications comprising machine learning methods are implemented, which use the generated classification as input. Based on the outcome of one or more implemented applications, a corresponding signal is released.

One advantage of the present invention is that it provides a test-pattern encoding extracted from the (non-image) data produced by AOI machines when inspecting printed circuit boards. This is especially advantageous in those cases where image data from the AOI vendors is not available. These non-image data provides a rich source of information that can be used for further applications, aiming at an optimization of the automated optical inspection. One possible application is the implementation of a machine learning based automated examination of the boards tagged by the AOI machine as faulty, aiming at a reduction of the false positives. Other applications can be aimed at finding correlations between the false positives and the corresponding test patterns, thereby pointing at potential improvements in the configuration of the detection algorithms employed by the AOI machines.

A further advantage of the present invention is that the system is configured to implement one machine learning model to deal with more than one test pattern, instead of providing a machine learning model for each test pattern. Since in some AOI machines the test-pattern libraries contain of the order of thousands of test patterns, the implementation provided in this invention provides a very efficient solution. This is also the case when new test patterns are added. Instead of providing a new machine learning model each time, one needs at the most to train the existing one with the new test patterns.

Advantageous embodiments and further developments follow from the dependent claims as well as from the description of the different preferred embodiments illustrated in the accompanying figures.

According to some embodiments, refinements, or variants of embodiments, the data obtained by the system comprises information about the configuration of the printed circuit board (PCB), including at least the position of the electronic components built on the PCB and the position of the electronic connections on the PCB.

The obtained data typically comprises measurement data points, where each measurement corresponds to a scanned window of the PCB where a test pattern is applied. Each measurement data point contains information about the measurement itself (metadata), such as the corresponding measurement time, test pattern and PCB, together with the outputs of the detection algorithm of the AOI machine, which are represented by features. These metadata and the measured features encode the information about the configuration of the inspected elements of the PCB. While image data is restricted by some vendors, this non-image data is available from most of the AOI machine producers.

According to some embodiments, refinements, or variants of embodiments, the application module further comprises a false-positive unit in a first application, configured to generate, based on the generated classification, a probability that a printed circuit board predicted by the automated optical inspection machine as defect is a false positive.

The application module provides a number of machine learning based applications, in order to further exploit the potential of the generated classification of test patterns performed by the artificial neural network. One of these applications is the reduction of false positives detected by the AOI machine. In some embodiments, the input of the false-positive unit is restricted to those measurements that were tagged, based on the applied test patterns, as showing defects. The false-positive unit is configured to identify (e.g., by providing a probability value) the false-positive cases in an automated way, thus optimizing the assembly line of the PCBs.

According to some embodiments, refinements, or variants of embodiments, the application module comprises a concatenation unit in a second application, configured to concatenate the output of the artificial neural network to a conventional machine learning system.

One of the advantages of the concatenation unit is that off-shelf machine learning models can use the results of the present invention as input, thereby improving their performance. The use of the concatenation unit enables cross test-pattern generalization for conventional machine learning solutions and algorithms. The resulting feature enrichment is provided by the concatenation unit as an upgrade to existing machine learning algorithms. In other words, a user can keep using his/her conventional off-the-shelf tool stack of machine learning algorithms. For example, the encoding of the test patterns (i.e., the output of the last layer of the artificial neural network) can be concatenated to the input of a Random Forest algorithm for the prediction of false-positives.

According to some embodiments, refinements, or variants of embodiments, the application module comprises a similarity search unit in a third application, configured to quantify the similarity of test patterns with a relative distance.

The encoder of the invention is trained to discriminate test patterns based on the observed measurement data. In doing so test patterns can be represented in a latent space, where encodings having similar properties cluster. Relative distances can be defined in this latent space, which provide connections between apparently different test patterns. For example, the presence of a new test pattern in a measurement might still be dealt with by the system of the invention by generalizing one or more existing test patterns which are deemed as similar (i.e., close in the latent similarity space according to the determined relative distance).

According to some embodiments, refinements, or variants of embodiments, the similarity search unit implements an algorithm, which, given an unidentified test pattern, is adapted to find the test pattern closest to the unidentified test pattern.

The similarity search unit can preferably implement an algorithm designed to determine the distances between known test patterns. This algorithm can however be also adapted to check the similarity of new test patterns with respect to already identified ones.

According to some embodiments, refinements, or variants of embodiments, the application module comprises an evaluation unit in a fourth application, configured to output a probability associated with the expected performance of the false-positive unit based on the results of the algorithm for the unidentified test pattern.

The evaluation unit assesses in advance how efficient the false-positive unit could be when a new test pattern appears. The produced probability can be preferably linked to the results of the algorithm of the similarity search unit when applied to new test patterns. This probability can therefore be proportional to the distance in similarity space between the new test pattern and the existing ones. As an illustration, consider two test patterns A and B. For test pattern A, sufficient evaluation data was available during the training phase of the artificial neural network, while for the test pattern B training data was scarce. Based on the similarity of the test patterns A and B determined by the similarity search unit, it can be decided whether to apply the machine learning solution to data containing the test pattern B or whether further training is needed.

According to some embodiments, refinements, or variants of embodiments, if the probability generated by the evaluation unit is below a predetermined probability threshold, the output data interface is further configured to generate a corresponding signal.

This signal can be a communication on a screen interface, where, e.g., the probability value (proportional to the expected performance of the false-positive unit) is listed. Based on this value, a user can then decide whether the use of the system of the invention is in this particular case worthwhile or another method is preferable.

According to some embodiments, refinements, or variants of embodiments, the system further comprises a test-pattern identification unit, which is configured to train the artificial neural network with unidentified test patterns if the probability generated by the evaluation unit is below a predetermined probability threshold.

This test-pattern identification unit provides the artificial neural network with an increasing number of test patterns to be inferred and therefore increases the performance of the system of the invention. Additionally, in this way the encoder of the invention can be kept up to date, for instance if new test patterns are released by the AOI machine producer.

According to some embodiments, refinements, or variants of embodiments, the application module comprises a correlation unit in a fifth application, configured to cluster the test patterns into groups based on their similarity and implement a correlation algorithm, adapted to search for correlations within the false-positive predictions of the automated optical identification machine.

The correlation algorithm can point in the direction of potential improvements in the configuration of the detection algorithms employed by the AOI machines, with the goal of increasing their efficiency and accordingly decreasing the number of false positives detected by the AOI machines.

According to some embodiments, refinements, or variants of embodiments, the architecture of the artificial neural network or parts thereof is implemented in a server or a cloud computing platform, from where it can be integrated as a pre-trained part of other neural network architectures. These neural network architectures can actually be designed for very diverse applications other than the false positive reduction discussed in the foregoing.

Although here, in the foregoing and also in the following, some functions are described as being performed by modules or units, it shall be understood that this does not necessarily mean that such modules or units are provided as entities separate from one another. In cases where one or more modules or units are provided as software, the modules or units may be implemented by program code sections or program code snippets, which may be distinct from one another but which may also be interwoven or integrated into one another.

Similarly, in cases where one or more modules or units are provided as hardware, the functions of one or more modules or units may be provided by one and the same hardware component, or the functions of several modules or units may be distributed over several hardware components, which need not necessarily correspond to the modules or units. Thus, any apparatus, system, method and so on which exhibits all of the features and functions ascribed to a specific module or unit shall be understood to comprise, or implement, said module or said unit. In particular, it is a possibility that all modules or units are implemented by program code executed by the computing device, for example a server or a cloud computing platform.

Where appropriate, the above-mentioned configurations and developments can be combined implementations can be combined with each other as desired, as far as this is reasonable. Further possible configurations, developments and implementations of the invention also include combinations, which are not explicitly mentioned, of features of the invention which have been described previously or are described in the following with reference to the embodiments. In particular, in this case, a person skilled in the art will also add individual aspects as improvements or supplements to the basic form of the present invention.

The present invention is described in greater detail in the following on the basis of the embodiments shown in the schematic figures of the drawings, in which:

Fig. 1   is a schematic depiction of a system for optimizing the automated optical inspection of printed circuit boards according to an embodiment of the present invention;

Fig. 2   is a block diagram showing an exemplary embodiment of a computer-implemented method for optimizing the automated optical inspection of printed circuit boards according to the present invention;

Fig. 3   is a schematic diagram showing the architecture of an artificial neural network according to an embodiment of the present invention;

Fig. 4   is a schematic illustration of an automated inspection system for the optical inspection of printed circuit boards comprising an automated optical inspection machine and the system of the invention;

Fig. 5   is a schematic block diagram illustrating a computer program product according to an embodiment of the third aspect of the present invention; and

Fig. 6   is a schematic block diagram illustrating a non-transitory computer-readable data storage medium according to an embodiment of the fourth aspect of the present invention.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

The numeration of the steps in the methods are meant to ease their description. They do not necessarily imply a certain ordering of the steps. In particular, several steps may be performed concurrently.

The detailed description includes specific details for the purpose of providing a thorough understanding of the present invention. However, it will be apparent to those skilled in the art that the present invention may be practised without these specific details.

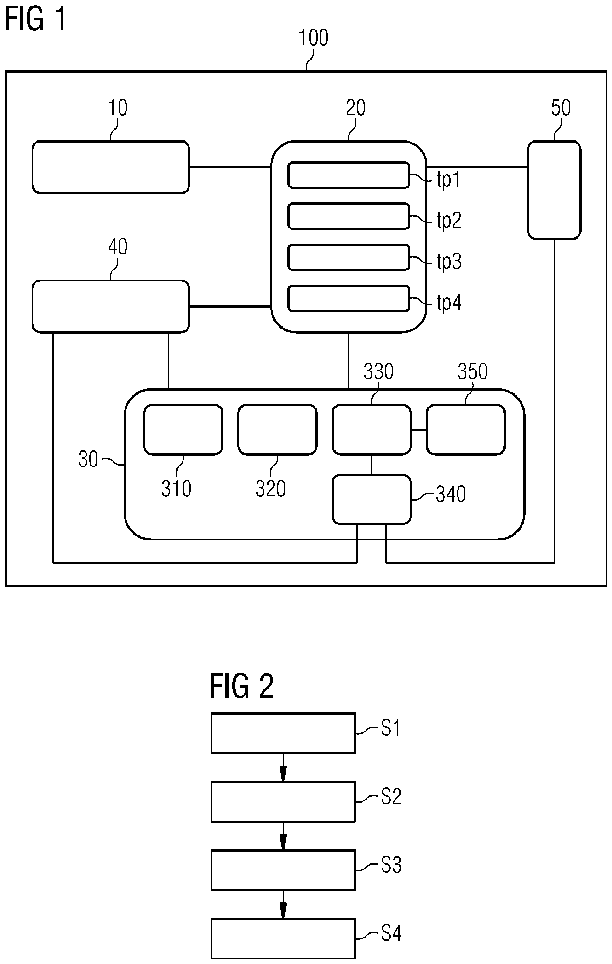

Fig. 1 shows a schematic depiction of a system 100 for optimizing the automated optical inspection of printed circuit boards according to an embodiment of the present invention.

The system 100 depicted in Fig. 1 comprises an input data interface 10, a classification module 20, an application module 30, an output interface 40, and a test-pattern identification unit 50.

The input data interface 10 is configured to obtain data produced by an AOI machine during its scanning of a PCB. The data obtained by the input data interface 10 may comprise measurement data points, each measurement corresponding to a scanned window of the PCB where a test pattern is applied. Each measurement data point contains information about the measurement itself (metadata), such as the corresponding measurement time, test pattern and PCB, together with the outputs of the detection algorithm of the AOI machine, which are represented by features.

The input data interface 10 can be any device capable of processing this combination of metadata and measured features that encode the information about the configuration of the PCB, such as the position of the electronic components built on the PCB and the position of the electronic connections on the PCB. The input data interface 10 can be connected to an AOI machine, wired or wireless or with a combination thereof.

The classification module 20 is configured to implement an artificial neural network, trained and adapted to classify the obtained data according to a number of test patterns. An artificial neural network is to be understood as a deep learning model to implement different data analysis methods, in particular those comprising a transformer neural network architecture.

The artificial neural network is trained with data from the AOI machine with a number of test patterns. The library of an AOI machine contains typically thousands of test patterns. For simplicity and just for illustration purposes, Fig. 1 shows four test patterns tp1-tp4. The artificial neural network of Fig. 1 is trained to provide a classification according to the test patterns tp1-tp4. The data obtained from the input data interface 10 contains different measurements, which are associated with the test patterns tp1-tp4. The classification module 20 is adapted to produce a representation of the test patterns tp1-tp4 (also referred to as a test-pattern encoding).

The application module 30 is configured to implement different machine learning based applications, which use as input the generated classification, i.e., the representation of the test patterns tp1-tp4 produced by the classification module 20.

In the embodiment shown in Fig. 1, the application module 30 comprises a false-positive unit 310, a concatenation unit 320, a similarity search unit 330, an evaluation unit 340 and a correlation unit 350. These units provide, respectively, a first, second, third, fourth and fifth application.

The false-positive unit 310 is configured to generate a probability that a printed circuit board predicted by the AOI machine as defect is a false positive. In some embodiments, the input of the false-positive unit is restricted to those measurements that were tagged, based on the applied test patterns, as showing defects. The false-positive unit is configured to identify (e.g., by providing a probability value) the false-positive cases in an automated way, thus optimizing the assembly line of the PCBs.

The concatenation unit 320 is configured to concatenate the output of the artificial neural network to a conventional machine learning system. In this way, off-the-shelf machine learning models can employ the results of the present invention, in particular the results of the test-pattern encoding, thereby improving their performance. The use of the concatenation unit enables cross test-pattern generalization for conventional machine learning solutions and algorithms. For example, the encoding of the test patterns (i.e., the output of the last layer of the artificial neural network) can be concatenated to the input of a Random Forest algorithm for the prediction of false-positives.

The similarity search unit 330 is configured to quantify the similarity of test patterns by computing a relative distance between them. The similarity search unit can preferably implement an algorithm designed to determine the distances between known test patterns or check the similarity of new test patterns with respect to already identified ones. The results of the similarity search unit 330 can be used to identify latent regularities between apparently different test patterns.

The evaluation unit 340 is configured to output a probability associated with the expected performance of the false-positive unit 310 when a new, unidentified test pattern is present. The evaluation unit assesses how efficient the false-positive unit 310 is expected to be when confronted with the new test pattern. The generated probability can be preferably linked to the results of the algorithm of the similarity search unit 330 when applied to the new test pattern.

The evaluation unit 340 is an example of an application provided by the application module 30 which requires a synergy with other applications, in this case with the one provided by the similarity search unit 330.

In some embodiments of the invention, if the probability generated by the evaluation unit 340 is below a predetermined probability threshold, a corresponding signal is generated, e.g., via the output data interface 40. Based on this signal it can be decided (e.g., by a user) whether to apply the machine learning solution in this particular case or not.

The correlation unit 350 is configured to cluster the test patterns into groups based on their similarity, wherein their similarity is provided by the similarity search unit 330, and implement a correlation algorithm, adapted to search for correlations within the false-positive predictions of the automated optical identification machine. The correlation algorithm can therefore point in the direction of potential improvements in the configuration of the detection algorithms employed by the AOI machines.

In some embodiment of the invention, such as the one depicted in Fig. 1, the system comprises a test-pattern identification unit 50, which is configured to train the artificial neural network with unidentified test patterns. This can be prompted by a probability value generated by the evaluation unit 340 being below a predetermined probability threshold. However, it can also be a way of increasing the library of test patterns that can be recognized by the artificial neural network of the invention. This way the encoder of the invention can also be kept up to date, for instance if new test patterns are released by a AOI machine producer.

The output interface 40 is a device configured to output a signal based on the outcome of the one or more implemented applications. This signal can be a communication on a screen interface, where, e.g., the probability value generated by the evaluation unit 340 is listed. Based on this value, a user can then decide whether the use of the system of the invention is warranted or another method is preferable.

In some embodiments, the output interface 40 can also provide a selection menu on a user interface from which a user can select the different applications to be executed.

In some other embodiments, the activation of the test-pattern identification unit 50 can also be managed from a user interface belonging to the output interface 40.

Fig. 2 is a block diagram showing an exemplary embodiment of a computer-implemented method for optimizing the automated optical inspection of printed circuit boards according to the present invention. The method can be preferably implemented with the computing system 100 described with respect to Fig. 1. The method comprises a number of steps.

In one step S1, data produced by an automated optical inspection machine during the inspection scans of a printed circuit board is obtained. This data can contain a combination of metadata and measured features.

In another step S2, a classification for the obtained data is generated through the use of a pre-trained artificial neural network, which was trained with data belonging to a number of test patterns tp1-tp4.

In a subsequent step S3, one or more applications are implemented, which use the generated classification as input. Possible applications have been described in relation with Fig. 1, in particular applications performed by the false-positive unit 310, the concatenation unit 320, the similarity search unit 330, the evaluation unit 340 and the correlation unit 350. In some embodiments, the step S3 can accordingly comprise a number of steps (not shown in the figure), such as:

a step S31, in which a probability that a PCB predicted by the AOI machine as defect is a false positive is generated;

a step S32, in which the output of the artificial neural network is concatenated to an off-the-shelf conventional machine learning system;

a step S33, in which the similarity of test patterns is quantified with a relative distance, wherein the test patterns can comprise test patterns outside of the classification (unidentified test patterns);

a step S34, in which a probability associated with the expected performance of a false-positive detection given an unidentified test pattern is calculated; or

a step S35, in which correlations are searched for within the false-positive predictions of the AOI machine based on the similarity of the test patterns.

The outcome of the one or more implemented applications in step S3 is then used in a step S4 to output a signal containing information about these outcomes.

In some embodiments, there is provided a step S5 (not shown in Fig. 2), in which the artificial neural network can be further trained with unidentified test patterns in order to upgrade and/or update the system of the invention.

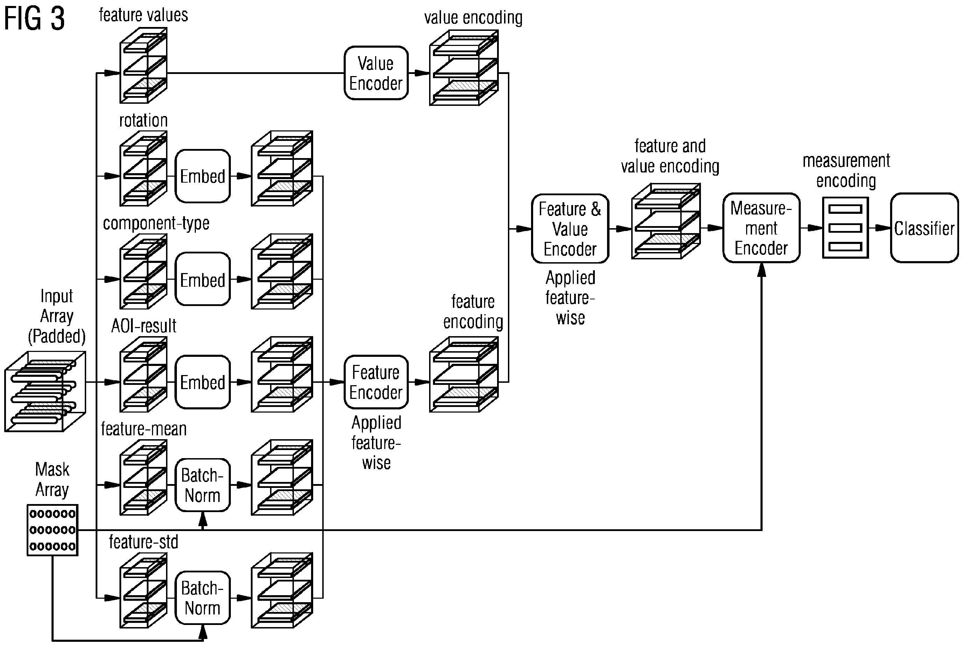

Fig. 3 is a schematic diagram showing the architecture of an artificial neural network according to an embodiment of the present invention.

The encoder of Fig. 3 is adapted to identify test patterns based on measured features from the measurements of the AOI machine, information about the distribution of the values of the measured features and information about the electronic component on which the measurement took place. The input data of the artificial neural network is represented by an Input Array, which comprises the measured features of each measurement together with contextualization information about the component rotation, the component type and the error the AOI machine has reported on each measurement. In order to ensure that the different measurements correspond to same sized inputs, a padding (a completion of null values in the string of features) is provided. A binary Mask Array is created, which indicates the position of the null values of the padding.

The Input Array is first split into its individual elements or variables: a feature value (continuous), a rotation (discrete), the component-type (discrete), the AOI result (discrete), the feature-mean (continuous) and the feature-standard-deviation (continuous). The discrete data is passed through an embedding layer, resulting in a multidimensional embedding vector. The feature statistics (mean and standard deviation) are passed through a Batch Norm layer to normalize them. The Mask Array is also processed to ignore the paddings during normalization. The embedded discrete data, the normalized feature mean and the standard deviation values are then concatenated and processed by a Feature Encoder. This Feature Encoder produces an encoding that describes semantics of the feature (without the value) in a latent space.

The Feature Encoder consists of a sequence of fully-connected neural network layers which is applied feature-wise, i.e., on the data of each feature. In some embodiments of the invention, the layers could be a single fully-connected layer with a ReLU activation function

$$u_{i,j} = \max\left(0, f_{i,j} W_u^T + b_u\right)$$

, where $f_{i,j}$ is the concatenated and encoded data of the feature and $W_u$ and $b_u$ are the learnable parameters of the neural network layer.

The feature values are encoded by a Value Encoder. The Value Encoder consists of a sequence of fully-connected neural network layers which is applied feature-wise, i.e., on each feature value individually. In some embodiments of the invention, the layers could be a single fully-connected layer with a ReLU activation function

$$r_{i,j} = \max\left(0, v_{i,j} W_r^T + b_r\right)$$

, where $v_{i,j}$ is the normalized feature value and $W_r$ and $b_r$ are the learnable parameters of the neural network layer.

The outputs of the Feature Encoder and the Value Encoder are then concatenated and passed to a Feature & Value Encoder that combines the encodings, producing a multidimensional encoding. The Feature & Value Encoder consists of a sequence of fully-connected neural network layers which is applied feature-wise. In some embodiments of the invention, the layers could be a single fully-connected layer with a ReLU activation function

$$z_{i,j} = \max\left(0, g_{i,j} W_z^T + b_z\right)$$

, where $g_{i,j}$ is the concatenation of the feature encoding and the value encoding and $W_z$ and $b_z$ are the learnable parameters of the neural network layer.

The information from all features of a measurement is processed by a Measurement Encoder, which uses the input Mask Array to take the padding (added null values for the features) into account. The Measurement Encoder fuses the output of the Feature & Value Encoder $z_{i,j}$ of all features $j$ (where $j$ refers to non-padded input) into a single encoding $q_i$, representing the data of the $i^{th}$ measurement in a fixed sized encoding. This encoding can be done with different architectures, e.g., performing a mean encoding, in which $q_i = \frac{1}{M}\sum_{j=0}^{M-1} z_{i,j}$, performing a Max encoding with $q_{i,k} = \max_{j\in\{0,1,...,M-1\}} z_{i,j,k}$, or performing an attention-based encoding. In the latter, a transformer architecture is used, where the set of feature encodings and the corresponding masks are first passed through multiple blocks of self-attention based encoding layers, followed by a cross-attention module.

The Classifier produces a representation for the test patterns $a_i = q_i W_a^T + b_a$, where $q_i$ is the encoding if the $i^{th}$ measurement. Further, it predicts a confidence value distribution $c_i = \sigma(\max(0, a_i)W_c^T + b_c)$, where $W_c$ and $b_c$ are the learnable parameters of the neural network layer and $\sigma$ is the softmax function, applied over the test patterns of all observed test patterns from the training set.

Training of the artificial neural network is performed using a dataset of measurements from an AOI machine and employing off-the-shelf stochastic gradient-based optimization methods. After training, the last layer of the overall architecture is removed such that the trained model returns the test pattern encoding $a_i$.

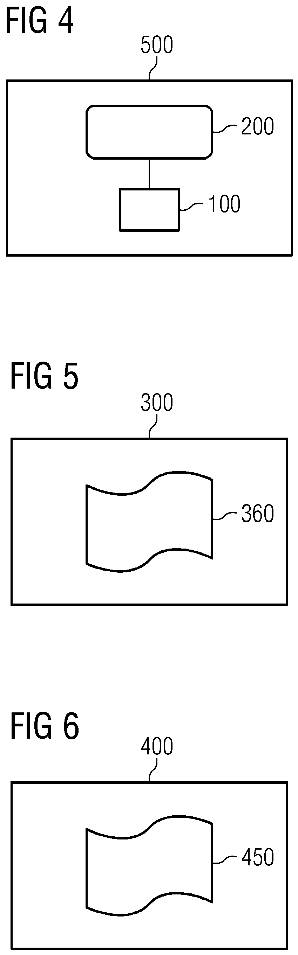

Fig. 4 is a schematic illustration of an automated inspection system 500 for the optical inspection of printed circuit boards comprising an automated optical inspection machine 200 and the system 100 of the invention. The system 100 is either implemented or connected (wired or wireless) to the automated optical inspection machine 200. In some embodiments, the system 100 is provided as an application program interface (API) to the automated optical inspection machine 200.

Fig. 5 shows a schematic block diagram illustrating a computer program product 300 according to an embodiment of the third aspect of the present invention. The computer program product 300 comprises executable program code 360 configured to, when executed, perform the method according to any embodiment of the second aspect of the present invention, in particular as it has been described with respect to the preceding figures.

Fig. 6 shows a schematic block diagram illustrating a non-transitory computer-readable data storage medium 400 according to an embodiment of the fourth aspect of the present invention. The data storage medium 400 comprises executable program code 450 configured to, when executed, perform the method according to any embodiment of the second aspect of the present invention, in particular as it has been described with respect to the preceding figures.

The non-transient computer-readable data storage medium may comprise, or consist of, any type of computer memory, in particular semiconductor memory such as a solid-state memory. The data storage medium may also comprise, or consist of, a CD, a DVD, a Blu-Ray-Disc, an USB memory stick or the like.

The previous description of the disclosed embodiments are merely examples of possible implementations, which are provided to enable any person skilled in the art to make or use the present invention. Various variations and modifications of these embodiments will be readily apparent to those skilled in the art, and the generic principles defined herein may be applied to other embodiments without departing from the spirit or scope of the present disclosure. Thus, the present invention is not intended to be limited to the embodiments shown herein but it is to be accorded the widest scope consistent with the principles and novel features disclosed herein. Therefore, the present invention is not to be limited except in accordance with the following claims.

## Claims

1. A system (100) for optimizing the automated optical inspection of printed circuit boards, the system (100) comprising:

   an input data interface (10) configured to obtain data from a printed circuit board produced by an automated optical inspection machine, wherein the data contains a number of measured features;
   a classification module (20) configured to implement an artificial neural network, trained and adapted to generate a classification of the obtained data based on a number of test patterns (tp1-tp4);
   an application module (30) configured to implement one or more applications from a set of applications using the generated classification as input; and
   an output interface (40) configured to output a signal based on the outcome of the one or more implemented applications.

2. The system according to claim 1, wherein the obtained data comprises information about the configuration of the printed circuit board, including at least the position of the electronic components built on the printed circuit board and the position of the electronic connections on the printed circuit board.

3. The system according to any of the previous claims, wherein the application module (30) comprises a false-positive unit (310) in a first application, configured to generate, based on the generated classification, a probability that a printed circuit board predicted by the automated optical inspection machine as defect is a false positive.

4. The system according to any of the previous claims, wherein the application module (30) comprises a concatenation unit (320) in a second application, configured to concatenate the output of the artificial neural network to a conventional machine learning system.

5. The system according to any of the previous claims, wherein the application module (30) further comprises a similarity search unit (330) in a third application, configured to quantify the similarity of test patterns (tp1-tp4) with a relative distance.

6. The system according to claim 5, wherein the similarity search unit (330) implements an algorithm, which, given an unidentified test pattern, is adapted to find the test pattern closest to the unidentified test pattern.

7. The system according to claim 6, wherein the application module (30) further comprises an evaluation unit (340) in a fourth application, configured to output a probability associated with the expected performance of the false-positive unit (310) based on the results of the algorithm for the unidentified test pattern.

8. The system according to claim 7, wherein if the probability generated by the evaluation unit (340) is below a predetermined probability threshold, the output data interface (40) is further configured to generate a corresponding signal.

9. The system according to claim 7, further comprising a test-pattern identification unit (50), which is configured to train the artificial neural network with unidentified test patterns if the probability generated by the evaluation unit (340) is below a predetermined probability threshold.

10. The system according to claim 5, wherein the application module (30) comprises a correlation unit (350) in a fifth application, configured to cluster the test patterns (tp1-tp4) into groups based on their similarity and implement a correlation algorithm, adapted to search for correlations within the false-positive predictions of the automated optical identification machine.

11. The system according to any of the previous claims, wherein the architecture of the artificial neural network or parts thereof is implemented in a server or a cloud computing platform, from where it can be integrated as a pre-trained part of other neural network architectures.

12. An automated inspection system (500) for the optical inspection of printed circuit boards comprising an automated optical inspection machine (200) and a computing system (100) according to any of the previous claims, wherein the computing system (100) is provided as an application program interface to the optical inspection machine (200).

13. A computer-implemented method for optimizing the automated optical inspection of printed circuit boards, preferably to be implemented with the system (100) according to any of the claims 1 to 12, comprising the steps:

> obtaining (S1) data from a printed circuit board produced by an automated optical inspection machine, wherein the data contains a number of measured features;
> generating (S2), using an artificial neural network trained on a number of test patterns (tp1-tp4), a classification for the obtained data based on the number of test patterns (tp1-tp4) ;
> implementing (S3) one or more applications from a set of applications using the generated classification as input; and
> outputting (S4) a signal based on the outcome of the one or more implemented applications.

14. A computer program product (300) comprising executable program code (360) which is configured, when executed, to perform the computer-implemented method according to claim 13.

15. A non-transient computer-readable data storage medium (400) comprising executable program code (450) which is configured, when executed, to perform the computer-implemented method according to claim 13.

FIG 1

FIG 2

FIG 3

feature values → Value Encoder → value encoding

rotation → Embed → feature and value encoding

component-type → Embed

Input Array (Padded)

AOI-result → Embed → Feature Encoder (Applied feature-wise) → feature encoding

Mask Array

feature-mean → Batch-Norm

feature-std → Batch-Norm

Feature & Value Encoder (Applied feature-wise) → feature and value encoding → Measurement Encoder → measurement encoding → Classifier

# FIG 4

500

200

100

# FIG 5

300

360

# FIG 6

400

450

Europäisches
Patentamt

European
Patent Office

Office européen
des brevets

## EUROPEAN SEARCH REPORT

Application Number

EP 23 16 3541

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DENG YU-SHAN ET AL: "Building an Automatic Defect Verification System Using Deep Neural Network for PCB Defect Classification", 2018 4TH INTERNATIONAL CONFERENCE ON FRONTIERS OF SIGNAL PROCESSING (ICFSP), IEEE, 24 September 2018 (2018-09-24), pages 145-149, XP033457713, DOI: 10.1109/ICFSP.2018.8552045 [retrieved on 2018-11-28] | 1-6, 11-15 | INV. G06T7/00 G01R31/309 G01N21/956 G06N3/02 H05K13/08 |
| A | * the whole document * | 7-10 | |
| | ----- | | |
| A | SCHLOSSER TOBIAS ET AL: "Improving automated visual fault inspection for semiconductor manufacturing using a hybrid multistage system of deep neural networks", JOURNAL OF INTELLIGENT MANUFACTURING, SPRINGER US, NEW YORK, vol. 33, no. 4, 25 January 2022 (2022-01-25), pages 1099-1123, XP037718208, ISSN: 0956-5515, DOI: 10.1007/S10845-021-01906-9 [retrieved on 2022-01-25] * the whole document * | 1-15 | |
| | ----- | | TECHNICAL FIELDS SEARCHED (IPC) |
| A | RESHADAT VAHIDEH ET AL: "Improving the Performance of Automated Optical Inspection (AOI) Using Machine Learning Classifiers", 2021 INTERNATIONAL CONFERENCE ON DATA AND SOFTWARE ENGINEERING (ICODSE), IEEE, 3 November 2021 (2021-11-03), pages 1-5, XP034057097, DOI: 10.1109/ICODSE53690.2021.9648445 [retrieved on 2021-12-13] * the whole document * | 1-15 | G06T G01R G01N G06N H05K |
| | ----- | | |

The present search report has been drawn up for all claims

| Place of search | Date of completion of the search | Examiner |
|---|---|---|
| Munich | 9 October 2023 | Wu, Zifeng |

EPO FORM 1503 03.82 (P04C01)